# EUROPEAN PATENT SPECIFICATION

(11) **EP 1 135 004 B1**
(45) Date of publication and mention of the grant of the patent: **21.05.2008**
(21) Application number: 01106714.7
(22) Date of filing: 16.03.2001
(51) Int. Cl.: H05B 33/04, B01D 53/04, B01D 53/14, B01D 53/26

(54) **Member for electroluminescent device and electroluminescent device having the same**
Material für elektrolumineszente Vorrichtung und elektrolumineszente Vorrichtung damit
Matériau pour dispositif électroluminescent et dispositif électroluminescent l'utilisant

(30) Priority: 16.03.2000 JP 2000074840
(43) Date of publication of application: 19.09.2001
(73) Proprietor: NITTO DENKO CORPORATION, Osaka (JP)
(72) Inventor: Nishii, Hiroyuki, Ibaraki-shi, Osaka (JP); Mashiko, Hiroaki, Ibaraki-shi, Osaka (JP)
(74) Representative: Grünecker, Kinkeldey, Stockmair & Schwanhäusser Anwaltssozietät

(56) References cited:
- EP-A- 0 500 382
- EP-A- 0 969 700
- EP-A- 1 115 267
- DE-A- 3 108 728
- US-A- 5 116 270
- US-A- 5 189 405
- DATABASE WPI Section Ch, Week 200176 Derwent Publications Ltd., London, GB; Class A88, AN 2001-658694 XP002225328 & JP 2001 198429 A (NITTO DENKO CORP), 24 July 2001 (2001-07-24)
- DATABASE WPI Section Ch, Week 200136 Derwent Publications Ltd., London, GB; Class A14, AN 2001-338284 XP002225329 & JP 2001 079369 A (NITTO DENKO CORP), 27 March 2001 (2001-03-27)

## Description

### FIELD OF THE INVENTION

This invention relates to a member used in an electroluminescent (hereinafter "EL") device and an EL device having the member.

### BACKGROUND OF THE INVENTION

The phenomenon of a substance's emitting light on electric field application is well known as electroluminecence (EL). A device utilizing the EL phenomenon is an EL device. Organic EL devices, one type of EL devices, have a laminate structure comprising a pair of electrodes and at least one organic light-emitting layer interposed therebetween, wherein electrons injected from one of the electrodes and holes injected from the other are combined in the organic light-emitting layer to generate light. The organic EL devices have such advantages as a wide angle of view, a high contrast, a low driving power, a small thickness, and a broad working temperature and are expected to be applicable to various items of equipment such as a display of portable equipment or a light-emitting device.

The drawback of the organic EL devices, however, lies in that their light-emitting performance properties, such as luminance and light-emission uniformity, undergo serious deterioration with time or in use under a high temperature condition. One of the causes of such deterioration is appearance of spots which do not emit light called dark spots. It is known that dark spots occur when moisture, oxygen or organic gas enters the laminate structure through defects on the negative electrode surface to induce separation between the organic light-emitting layer and the negative electrode or oxidation of the negative electrode surface, resulting in a failure of electrical connection. The moisture, oxygen or organic gas which can give rise to the dark spots can exist in the atmosphere inside the device, or penetrate from the outside, or be desorbed from constituent parts or materials where it has been adsorbed and come into contact with the laminate structure to cause dark spots.

JP-A-9-148066 (The term "JP-A" as used herein means an "unexamined published Japanese patent application") proposes an organic EL device having a means for preventing moisture from penetrating inside the laminate structure, in which an alkali or alkaline earth metal oxide that keeps solid even after moisture adsorption is fixed as a desiccant inside a sealed housing, such as a glass housing. However, the proposed desiccant that remains solid even after moisture adsorption needs extra time to prepare in a solid form. The desiccant, being apt to break or disintegrate in handling, is difficult to fix inside the organic EL device. The desiccant is incapable of removing oxygen and organic gas. It is difficult to adjust the desiccant's ability to adsorb moisture.

US 5189405 discloses an electroluminescent panel comprising a moisture absorption sheet and a plastic film having moisture-proof property and gas barrier property.

### SUMMARY OF THE INVENTION

To address the above problems, it is an object of the present invention to provide a member to be used in an EL device which removes a gaseous component that can cause deterioration of light-emitting performance of the EL device, which can easily be fitted inside the EL device, and of which the gaseous component-removing performance is adjustable.

Another object of the present invention is to provide an EL device having the member.

The above objects are accomplished by a member for an EL device comprising a container a part of which is made of a porous material and a removing agent capable of removing a prescribed gaseous component, the removing agent being contained in the container and an EL device having the member inside.

The present inventors have conducted extensive researches, seeking a member for EL devices which is capable of removing gaseous components that will induce deterioration of the light-emitting performance of EL devices, which can be fitted inside an EL device with ease, and of which the gaseous component removing ability is adjustable. They have found as a result that a container a part of which is made of a porous material and which contains a removing agent removing harmful gaseous components that may cause deterioration of the light-emitting performance is easy to be fit into the inside of an EL device, which is ready to be made effective on not only moisture but oxygen and organic gases by appropriately selecting the removing agent, and of which the gas permeability influential on the lifetime and the performance of the removing agent can be controlled by appropriately adjusting the ratio of the part made of the porous material in the whole container.

### BRIEF DESCRIPTION OF THE DRAWINGS

Fig. 1 is a cross-section of an embodiment of the member for EL devices according to the present invention.
Fig. 2 is a perspective view of the member shown in Fig. 1.
Fig. 3 is an exploded perspective view of a porous sheet used in the present invention.
Fig. 4 is a cross-section of another embodiment of the member for EL devices according to the present invention.
Fig. 5 is an exploded perspective view of the member shown in Fig. 4.
Fig. 6 is a cross-section of an organic EL device having the member according to the present invention.

### Description of the Reference Numerals and Signs

1: a member for an EL device
11: a porous sheet
12: a removing agent
13: a non-porous sheet

### DETAILED DESCRIPTION OF THE INVENTION

The member according to the present invention can easily be attached to the inside of an EL device, where the above-described harmful gaseous components are let to reach the removing agent and thus removed. Enclosed within the container, the removing agent is not exposed so that it is less influential on human even when it is highly reactive. Even though the removing agent is in a particle or powder form or even where the removing agent is likely to come off the place where it should be, it is prevented from coming into direct contact with and doing damage to the laminate having the light-emitting layer. The ease of fitting the member reduces the cost for the fitting and will make it feasible to automate the fitting operation. The gas permeability of the member (permeability to the harmful gaseous components) which affects the lifetime and the performance of the removing agent, can be adjusted simply by varying the ratio of the part made of a porous material in the whole container, which is easier than adjusting the gas permeability by selection of the porous material itself. The strength of the member, which is important in handling generally or in picking up in automated production, can be adjusted by enhancing the strength of the non-porous part (the part other than the porous material-made part), which is easier than enhancing shape retention of the porous material itself (by increasing the thickness, etc.).

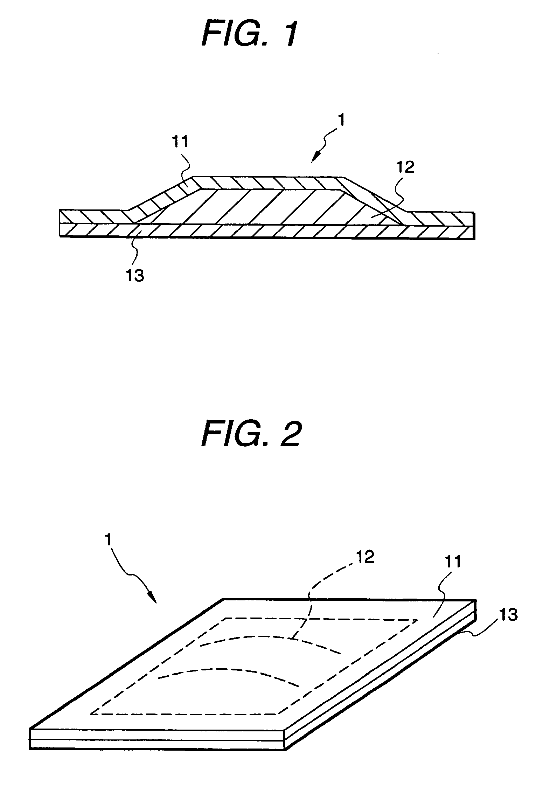

An embodiment of the member according to the present invention is shown in Figs. 1 and 2. The member 1 shown is made up of an upper porous sheet 11 and a lower non-porous sheet 13 which are joined to each other at their peripheral portion by, e.g., heat-sealing, and a removing agent 12 capable of removing a prescribed gaseous component(s), which is held in between the sheets 11 and 13.

The material which makes the porous sheet 11 preferably includes, but is not limited to, thermoplastic resins from the standpoint of processability. In particular, polyolefin-based resins, such as polypropylene, polyethylene, poly-4-methyl-pentene-1, and poly-1-butene, are preferred because of their processability in making openings small enough to prevent the removing agent 12 from falling through, inexpensiveness, and suitability to recycling. The resins may be either homopolymers or copolymers. Two or more kinds of resins may be used as a blend. In addition to the polyolefins, polytetrafluoroethylene is also a preferred material for the porous sheet 11.

Methods of making the porous sheet 11 of, for example, the thermoplastic resin include (1) a dry process comprising extruding a molten resin into film and stretching the extruded film at low temperature and then at high temperature to made the film porous, (2) a wet process comprising extruding a molten resin mixed with an extractable into film, stretching the extruded film, and removing the extractable by solvent extraction, etc. to leave pores, and (3) a process comprising fusing resin particles under pressure to form a porous block, which is sliced into film or from which a container shape, etc. is carved.

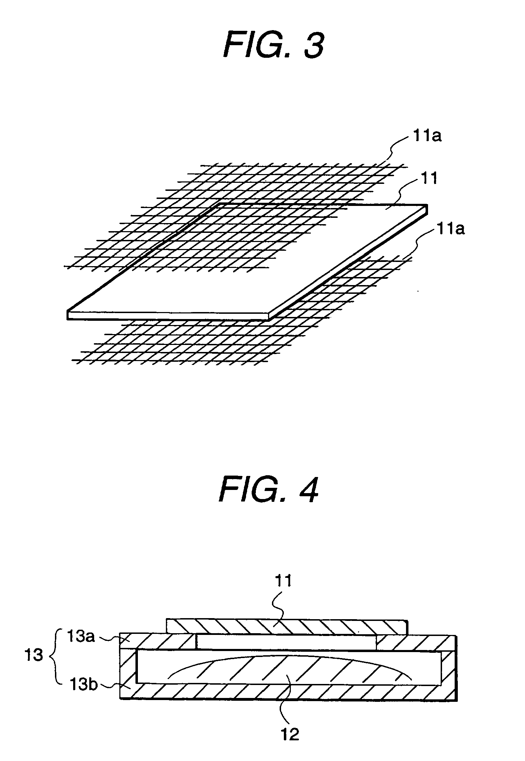

The porous sheet 11 can have a laminate structure composed of a plurality of films. For example, the porous sheet 11 can be laminated with an air-permeable reinforcing material, such as a net, nonwoven fabric, a polyolefin porous film, woven fabric or paper, to provide an air-permeable laminate sheet with enhanced strength. An example of such a laminate sheet is shown in Fig. 3, in which a net lla is superposed on both sides of the porous sheet 11. The reinforcing material, such as the net lla, may be provided on only one side of the porous sheet 11.

It is preferred for the porous sheet 11 to have a thickness of 5 µm or greater, particularly 10 to 1000 µm, in view of strength. The average pore size, while dependent on the kinds of the removing agent 12, is generally 100 µm or smaller, preferably 0.05 to 50 µm, for preventing the removing agent from falling through.

The materials making the non-porous sheet 13 include, but are not limited to, plastics and metals. Those made of thermoplastic resins are preferred for heat-sealability to the porous sheet 11.

The removing agent 12 which can be used in the present invention includes, but is not limited to, adsorbents, hygroscopic agents (desiccants), disoxidants (oxygen absorbers), and compounds generally employed as organic gas adsorbents. These removing agents can be used either individually or as a combination of two or more thereof.

The hygroscopic agents include compounds physically adsorbing moisture and compounds chemically reacting with moisture. Such compounds include silica gel, molecular sieves, activated alumina, alkali metal oxides, alkaline earth metal oxides, sulfates, carbonates, diphosphorus pentoxide, calcium hydroxide, lithium aluminum hydroxide, metal halides, perchlorates, and organic substances. These substances can be used either individually or as a mixture thereof.

The disoxidants include activated carbon, silica gel, molecular sieves, magnesium oxide, and iron oxide. They can be used either individually or as a mixture thereof.

The compounds capable of adsorbing organic gas include activated carbon, silica gel, and molecular sieves. They can be used either individually or as a mixture thereof.

The member 1 according to the above-described embodiment can be formed by interposing the removing agent 12 between the porous sheet 11 and the non-porous sheet 13 as shown in Figs. 1 and 2, and the peripheries of the two sheets 11 and 13 are sealed by, for example, application of an adhesive or a pressure-sensitive adhesive, heat-sealing, mechanical intermeshing, and the like. The non-porous sheet 13 made of the thermoplastic resin is suitable to be heat-sealed.

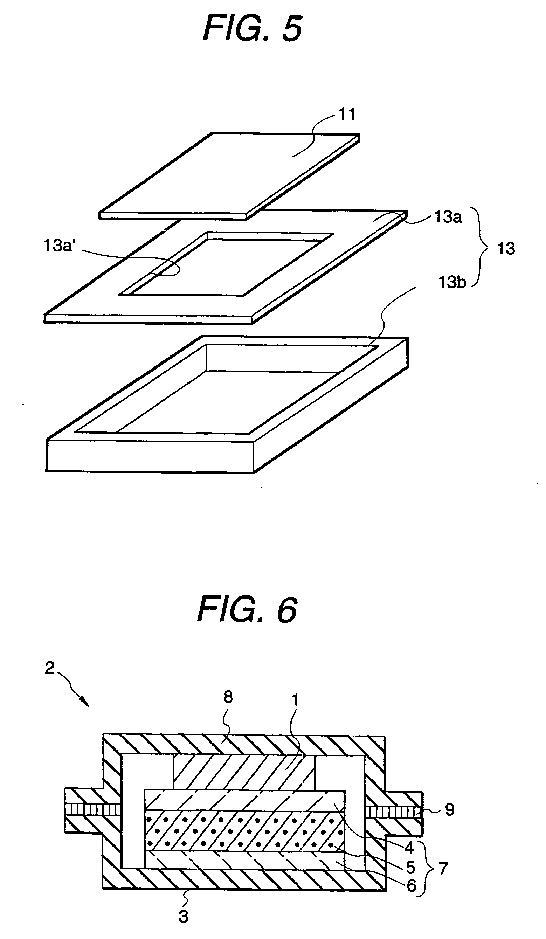

Another embodiment of the member 1 for EL devices is shown in Figs. 4 and 5, which is formed by putting the removing agent 12 into a container 13 made of the non-porous sheet 13 (a container 13b with a lid 13a having an opening 13a') and covering the opening 13a' with the porous sheet 11. The means for adhering the porous sheet 11 to the non-porous sheet container 13 includes, but it not limited to, application of an adhesive. The member 1 according to this embodiment has an increased surface area ratio of the non-porous sheet 13 than that of the first embodiment, which makes it possible to suppress the consumption of the removing agent 12 thereby to extend its lifetime and to improve the shape retention of the member 1.

The member 1 according to the present invention is used in the inside of, for example, an organic EL device as shown in Fig. 6. The organic EL device 2 shown in Fig. 6 comprises, in sequence, a surface substrate 3, a laminate element 7, and a backing substrate 8. The laminate element 7 comprises a positive electrode 4, an organic light-emitting layer 5, and a negative electrode 6. The surface substrate 3 and the backing substrate 8 are sealed together with a sealing compound 9 to constitute a closed housing. The organic EL device 2 is assembled by fixing the laminate element 7 to the inner surface of the surface substrate 3, fixing the member 1 to the inner surface of the backing substrate 8, joining the two substrates 3 and 8 with the laminate element 7 and the member 1 facing each other, and sealing the joint with the sealing compound 9, such as an adhesive. The member 1 may be put inside the organic EL device 2 in a non-fixed state.

While not limiting, the member 1 can be fixed inside the organic EL device 2 with an adhesive or by means of a fastener, such as a metallic fitment, or a frame or a sill which is provided inside the device 2 to prevent the member 1 from moving. From the standpoint of workability and space saving, fixing with an adhesive is preferred. The adhesive is preferably applied to the outer surface of the non-porous sheet 13 to ensure the fixing.

The adhesive which can be used for fixing the member 1 includes pressure-sensitive adhesives (self-adhesives), hot-melt adhesives, UV- or heat-curing adhesives, and two pack type adhesives. Pressure-sensitive adhesives are preferred for easy fixing, while UV-curing adhesives, especially acrylic adhesives, are preferred for minimizing influences on the laminate element 7. Suitable pressure-sensitive adhesives include silicone type adhesives, acrylic adhesives, and rubber adhesives.

The fixing operation can be automated in the following manner, for example. A plurality of the members 1 having on one side thereof a pressure-sensitive adhesive layer are temporarily stuck in alignment to a release sheet of continuous length and successively picked up and fixed to the inside of the organic EL device 2 by an automatic loader.

The organic EL device 2 thus produced has a function of removing gaseous components which may do damage to the inside laminate element 7.

While the present invention has been described with particular reference to an organic EL device, the invention relates to a member for EL devices and an EL device having the same, not being limited to an "organic" EL device.

The member for EL devices according to the present invention comprises a container a part of which is made of a porous material and a removing agent which is capable of removing at least one gaseous component that may adversely affect an EL device and which is contained in the container. Since the removing agent is not exposed but put within the container, the member is easily fitted into an EL device, influences of the removing agent on human, even if highly reactive, are lessened, and the fitting of the member into an EL device could be automated. The member of the present invention can be made effective on any one or more or all of moisture, oxygen, and organic gas simply by selecting the removing agent to be put into the container. The permeability of the member to the gaseous components, which affects the lifetime and the performance of the removing agent, is adjustable simply by varying the ratio of the part made of a porous material in the whole container. Such gas permeability control is easier than by selection of the porous material itself. The strength of the member, which is important in handling generally or in picking up in automated production, can easily be adjusted by enhancing the strength of the non-porous part (the part other than the porous material-made part). Such strength control is easier than by securing the shape retention of the porous material itself by, for example, increasing the thickness. In particular, the member of the type which is composed of upper and lower sheets, one porous and the other non-porous, which are sealed together at their periphery with a removing agent held therebetween is easy to make. The member can be made durable against an increased weight of the removing agent by using the porous sheet as laminated with a reinforcing sheet, such as nonwoven fabric. By use of a polyolefin-based resin, the porous sheet can be fabricated easily, with a controlled pore size so as not to allow the removing agent to fall through the openings. Freed of gaseous components having adverse influences on the EL performance, the EL device containing the member of the invention has an extended service life.

## Claims

1. A member (1) for an electroluminescent device comprising
a container (13) made of a non-porous material, and
a removing agent (12) capable of removing a prescribed gaseous component, the removing agent (12) being contained in said container (13),
**characterized in**
**that** said member (1) comprises a sheet (11, 11 a) being an air-permeable laminate sheet made of a porous sheet (11) and a reinforcing sheet (11a),
**that** said container (13) is comprised of an other container (13b) and a lid (13a) having an opening (13a'), and
**that** said sheet (11, 11a) covers said opening (13a') and being joined together with said lid (13a) at their peripheries.

2. The member (1) according to claim 1, **characterized in that** said reinforcing sheet (11 a) is nonwoven fabric.

3. The member (1) according to claim 1, **characterized in that** said porous sheet (11) comprises a polyolefin-based resin.

4. The member (1) according to claim 2, **characterized in that** said removing agent (12) is capable of removing at least one of moisture, oxygen and organic vapors.

5. An electroluminescent device (2)
**characterized in**
**that** a member (1) according to any of claims 1 to 4 is used.

## Patentansprüche

1. Material (1) für eine elektrolumineszente Vorrichtung umfassend
einen Behälter (13) hergestellt aus einem porenfreien Material, und
ein Entfernungsmittel (12) vorgesehen zum Entfernen einer vorbestimmten gasförmigen Komponente, wobei das Entfernungsmittel (12) in dem Behälter (13) enthalten ist,
**dadurch gekennzeichnet,**
**dass** das Material (1) eine Folie (11, 11a) umfasst, welches eine luftdurchlässige Verbundfolie hergestellt aus einer porösen Folie (11) und einer Verstärkungsfolie (11a) ist,
**dass** der Behälter (13) einen weiteren Behälter (13b) und einen Deckel (13a) mit einer Öffnung (13a') umfasst, und
**dass** die Folie (11, 11a) die Öffnung (13a') abdeckt und mit dem Deckel (13a) an dessen Peripherie verbunden ist.

2. Material (1) nach Anspruch 1, **dadurch gekennzeichnet, dass** die Verstärkungsfolie (11a) ein Vliesstoff ist.

3. Material (1) nach Anspruch 1, **dadurch gekennzeichnet, dass** die poröse Folie (11) ein auf Polyolefin basierendes Harz umfasst.

4. Material (1) nach Anspruch 2, **dadurch gekennzeichnet, dass** das Entfernungsmittel (12) vorgesehen ist, wenigstens Feuchtigkeit, Sauerstoff und/oder organische Dämpfe zu entfernen.

5. Elektrolumineszente Vorrichtung (2), **dadurch gekennzeichnet, dass** die Vorrichtung ein Material (1) nach einem der Ansprüche 1 bis 4 verwendet.

## Revendications

1. Elément (1) pour un dispositif électroluminescent comprenant
un contenant (13) préparé à partir d'un matériau non poreux, et
un agent d'élimination (12) pouvant éliminer un composant gazeux imposé, l'agent d'élimination (12) étant contenu dans ledit dans ledit contenant (13),
**caractérisé en ce que**
ledit élément (1) comprend une feuille (11, 11a) étant une feuille stratifiée perméable à l'air préparée à partir d'une feuille poreuse (11) et d'une feuille de renforcement (11a),
ledit contenant (13) est constitué d'un autre contenant (13b) et d'un couvercle (13a) ayant une ouverture (13a'), et
ladite feuille (11, 11a) recouvre ladite ouverture (13a') et est liée audit couvercle (13a) en leurs périphéries.

2. Elément (1) selon la revendication 1, **caractérisé en ce que** ladite feuille de renforcement (11a) est un tissu non tissé.

3. Elément (1) selon la revendication 1, **caractérisé en ce que** ladite feuille poreuse (11) comprend une résine à base de polyoléfine.

4. Elément (1) selon la revendication 2, **caractérisé en ce que** ledit agent d'élimination (12) peut éliminer au moins une des vapeurs de moisissures, d'oxygène et organiques.

5. Dispositif électroluminescent (2) **caractérisé en ce qu'**un élément (1) selon l'une quelconque des revendications 1 à 4 est utilisé.
